# EUROPEAN PATENT APPLICATION

(11) **EP 1 087 651 A1**
(43) Date of publication of application: **28.03.2001**
(21) Application number: 99307467.3
(22) Date of filing: 21.09.1999
(51) Int. Cl.: H05K 7/14, H05K 9/00

(54) **Screen on circuit board, and process for its production**

(71) Applicant: LUCENT TECHNOLOGIES INC., Murray Hill, New Jersey 07974-0636 (US)
(72) Inventor: Ritter, Kai-Uwe, Roth 91154 (DE); Schuh, Albrecht I., Nurnberg, Bayern 90427 (DE)
(74) Representative: Williams, David John

(57) **Abstract**

There is described a screen-circuit board assembly, comprising: a circuit board (10) having slots (11) with edges (12) and through which insertion portions (21) of the screen (20) extend; at least one spring clamp (1) allocated to the slots (11) and forming a slot cavity space (7), wherein the at least one spring clamp comprises supporting legs (2) and clamp side-walls (3). Each supporting leg (2) is soldered to an associated edge (12) of the slot to which it is allocated. At least one of the clamp side-walls (3) carries at least one spring member (5) in order to clamp and electrically connect the respective insertion portion (21) of the screen (20) to the circuit board (10). A process for the production of such screen-circuit boards is also disclosed.

## Description

The invention relates to a screen, which is to be provided with screen chambers, on a circuit board. The invention also relates to a process for the production of screens on circuit boards.

The electronic circuits formed on circuit boards are frequently screened from each other and against the environment. Screen chambers are frequently formed for this purpose, and are placed in contact with the associated circuit board. The screen can take on different embodiments.

The screen can be constituted as a sheet metal frame with sheet metal covers, wherein the screen chambers are separated from one another by sheet metal walls. The sheet metal frames have fastening tabs or fastening pins, which are pushed into slots or bores of the circuit board, In order to be soldered to the circuit board by a wave soldering method. The accessibility of the screen chambers is obtained via the covers. The latter must tightly seal the chamber electrically, which makes necessary a contact, of a problematic nature, between the frame and the cover. The electronic circuit enclosed in the chamber, without a removable cover, is no longer accessible for testing and repair purposes.

The screening can also take place with metallized plastic frames, and the contact between the screen walls and the circuit board then takes place by a high contact pressure. This gives rise to difficulties in placing the frame, and as a result additional conductive elastomers, or the like with a sheath of conductive plating, are utilized. The required high contact pressure is produced by a number of screw connections.

Plastic frames which can be closed with a cover can also be used similarly to sheet metal frames. The metallized plastic of the frame must however be resistant to high temperatures, so that soldering processes can be used. When the plastic frame is constituted with pins which extend through slots of the circuit board, wave soldering or manual soldering is concerned,, and when the plastic frame abuts with a flange, reflow soldering is concerned. Here also, an expensive contacting of the cover onto the screening frame is required.

The screen can also consist of a single screening hood, wherein a screening frame provided with a cover is set and soldered onto the circuit board for each required chamber. The cover is indeed removable, but closing the cover again brings problems. The hoods can of course only screen the regions of the circuit board which they cover. Regions of the circuit board consequently remain unscreened. Many sizes of screening hoods are required, but only a small number of standard sizes is feasible, for cost reasons.

As far as plastic frames have to be permanently pressed with high pressure onto a circuit board, there is a general problem with the flow behavior of plastics. The contact between the plastic frame and the circuit board becomes worse because of this phenomenon.

The invention has as its object to provide, for screening chambers, a fastening and contacting system which can be versatile in use and can be cost-effectively produced.

The set object is attained by the features and measures of the independent claims.

In detail, the circuit boards are provided with slots through which portions of the screens extend, and are thereby fastened and also electrically connected to the circuit board. For this purpose, the circuit board slots have spring clamps which are soldered to the circuit board and carry, In the depth of the slot, spring members between which the engaging screen walls are clamped fast. The contact faces of the spring members and the spring paths can be made relatively large, so that the flow behavior of the plastic used in the screen does not have negative effects on the fastening and contacting system. Accordingly, expensive plastic material does not need to be used for the screen.

The core of the fastening and contacting system consists of the spring clamps, which have supporting legs for the circuit board with which they are soldered to the circuit board, and which have a series of springs or spring members With which the screen chambers are fastened and contacted. Thus the connection between the circuit board and the screen is releasable.

Automatic insertion machines can be used for the mounting of the spring clamps to the circuit board, for example, those with heads equipped with suction pipes in order to suck the spring clamps at their supporting legs and deposit them onto the circuit board, where the spring clamps are fastened, for example by reflow soldering. The screens also can if necessary be inserted into the spring clamps with automatic insertion machines.

Further details of the invention will become apparent from the following description of embodiment examples.
- Fig. 1: shows a cross section through a spring clamp;
- Fig. 2: shows a section along II-II in Fig. 1;
- Fig. 3: shows a section through the crossover region between a circuit board 91 and a screen fastening;
- Fig. 4: shows a further crossover region with an upright screen fastening;
- Fig. 5: shows a cross section through a further spring clamp; and
- Fig. 6: shows a view according to a section along V-V in Fig. 5.

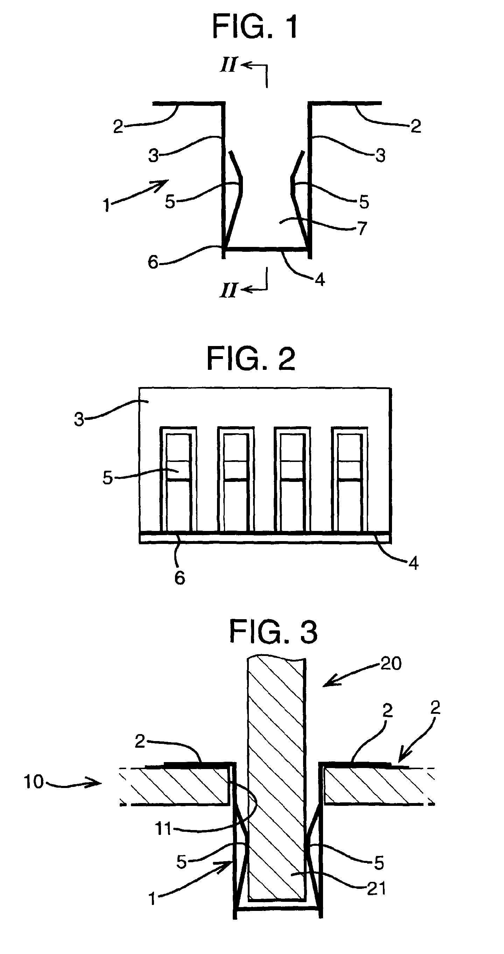

Figs. 1 and 2 show a first embodiment of a spring clamp 1, which has two supporting legs 2, clamp sidewalls 3 running transversely of these, a clamp bridging wall 4 and two rows of spring members 5. The clamp sidewalls 3 form with the bridging wall 4 a trough or interspace 7 of U-shaped cross section which is narrowed like a nozzle by the rows of spring members 5.

The spring clamp 1 can be formed of sheet metal, the individual spring members 5 being stamped out of wall portions of the clamp sidewalls and bent inward. The stamped-out wall portions form tongues which are connected to their respective sidewall 3 at 6, and otherwise project with a kneed bend into the interspace of the sidewalls 3. The cross section of the space between opposed spring members 5 tapers and then widens again. This can be termed "bulging" into the interspace 7.

Fig. 3 shows a section through a circuit board 10 In the region of a slot 11 whose upper edges bear solder strips 12. As is apparent, the spring clamp 1 is pushed into the slot 11 from above, so that the legs 2 come to abut the solder strips 12 and are mechanically and electrically connected by reflow soldering.

The circuit board 10 has several such slots 11 which serve for fastening and contacting of a screen 20 which for this purpose has chamber walls or pin-like feet 21 as insertion portions. The screen is pushed with its insertion portions 21 from above into the interspace 7 of the spring clamp 1, and the springs 5 then carry out the mechanical holding and the contacting. It is possible for the screen 20 together with the circuit board to form a screen chamber which can be removed from the circuit board in order to test the electronic circuits, and can be reinserted. In contrast to the former use of springs for mediation of the electrical contact, only one critical contact point is present here, as is by friction and pressure between the surface of the screen 20 and the respective spring member 5. Other critical places are eliminated by the use of the solder at 12.

The material of the screen 20 can be metallized plastic, which does not have to be temperature resistant and is therefore cheap, since it does not need to be soldered for contacting. Due to the numerous spring members 5, a high specific pressure does not have to be used to hold the screen 20 mechanically and contact it electrically. The screen can have planar external sides, as shown; however, it is also possible to permit the springs to engage in latching recesses of the screen 20.Sheet metal may also be used as the material of the screen.

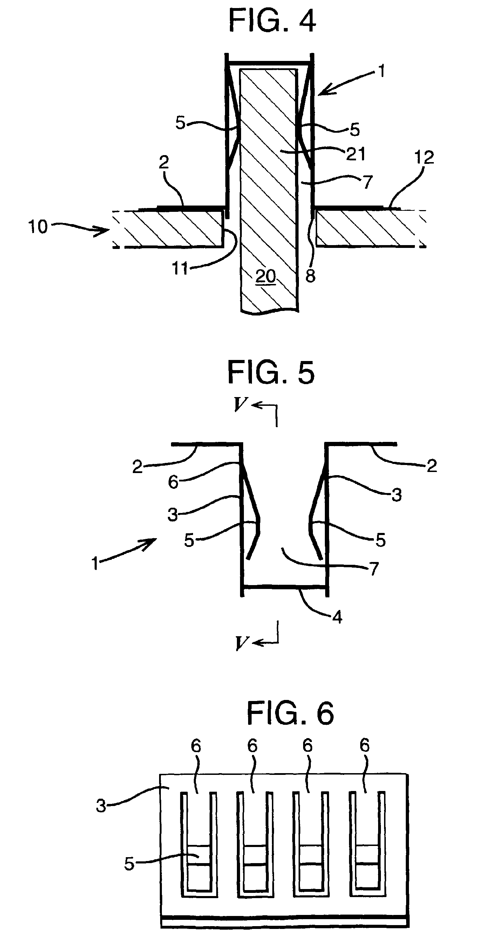

Fig. 4 shows another mode of installation of the screen. Corresponding parts are given the same reference numbers. As is apparent, the spring clamp 1 has a hat-shaped cross section, the interspace 7 of which is directed upward as the slot cavity space, and the supporting legs 2 are accordingly installed below. The sidewalls 3 can be slightly prolonged downward, as indicated at 8, in order to insert the spring clamp I onto the slot 11. The fastening of the spring clamp I to the circuit board takes place in the manner already described. The screen 20 is inserted from below into the slot depth space 7 and together with the circuit board 10 forms screen chambers which extend below the circuit board 10.

The embodiments of Figs. 1-3 can be combined with the embodiment according to Figs. 4-6 when the circuit board 10 is to be screened from both sides.

Figs. 5 and 6 show embodiments of the spring clamp 1 in which the springs 5 are suspended above, i.e., have connecting webs 6 to the remainder of the sidewalls 3 when an arrangement as in Fig. 1 is selected.

The spring clamps 1 of all the embodiments can be produced as strips or in small pieces (as mass-produced articles). The required slot lengths can be produced from several spring clamps by aligning these short clamp pieces. According to the state of the art with which the invention is compared, the following advantages result:

The connection between the circuit board and the screen is releasable.

There is only one electrical contact point for each spring, and it comes about by friction and pressure; the second electrical connection point of the spring takes place by means of a soldered place.

The portions of the screen extending through the slot provide an additional screening effect in comparison with screens which only abut on the circuit board.

The screen is not soldered and can therefore be produced from cheaper plastic.

The requirements of flatness of the screen are small, and tolerances can easily be equalized.

No screw fastening is necessary.

The individual portions of the screening system can be inserted by automatic machines.

The contacting is relatively defined and there is only one electrical connection point per spring member.

The spring clamps are set or inserted from above onto the circuit board, and there is no danger of falling out during reflow soldering.

The spring clamps can be produced and used as standard parts.

However, embodiments of the spring clamps which are specific for the application are also possible.

The electronic circuit on the circuit board is easily accessible for test and repair purposes, due to the easy releasability of the screen.

## Claims

1. Screen-circuit board assembly, comprising
a circuit board (10), said circuit board having slots (11) with edges (12) and through which insertion portions (21) of the screen (20) extend;
at least one spring clamp (1), said at least one spring clamp being allocated to the slots (11) and forming a slot cavity space (7), and said at least one spring clamp comprising supporting legs (2) and clamp sidewalls (3);
each supporting leg (2) being soldered to an associated edge (12) of the slot to which it is allocated;
at least one of said clamp sidewalls (3) carrying at least one spring member (5) in order to clamp and electrically connect the respective insertion portion (21) of the screen (20) to the circuit board (10).

2. Screen according to claim 1, wherein
the spring members (1), extending from the clamp sidewalls (3), form inward-extending bulges to one another.

3. Screen according to claims 1 and 2, wherein
several spring members (5) per slot cavity space (7) are arranged adjacently to one another.

4. Screen according to one of claims 1-3, wherein the spring members (5) are formed from wall portions of the clamps.

5. Screen according to one of claims 1-4, wherein the clamp sidewalls (3) project downwardly through the associated slot (11) of the circuit board (10).

6. Screen according to one of claims 1-4, wherein the clamp sidewalls (3) project downwardly through the associated slot (11) of the circuit board (10).

7. Screen according to one of claims 1-6, wherein the insertion portions (21) of the screen (20) are provided with indentations so as to latchingly engage the spring members.

8. Process for the production of screens on circuit boards, comprising the following steps:
forming slots (11) in the circuit board (10), having lateral edges;
installing solder material strips (12) on certain lateral edges of the slots (11);
applying supporting legs (2) of spring clamps (1), which are constituted according to one of claims 1-4 and which have said supporting legs, onto solder material strips (12) in order to form slot cavity spaces (7);
melting the solder material strips and then allowing to cool in order to connect the supporting legs (2) mechanically and electrically to the lateral edges of the circuit board slots (11);
inserting screens (20) in associated slot cavity spaces.
